# EUROPEAN PATENT APPLICATION

(11) **EP 4 625 041 A1**
(43) Date of publication of application: **01.10.2025**
(21) Application number: 24167835.8
(22) Date of filing: 29.03.2024
(51) Int. Cl.: G03F 7/00, H01L 21/683, H01L 21/687, H02N 13/00

(54) **ELECTROSTATIC CLAMP**

(71) Applicant: ASML Netherlands B.V., 5500 AH Veldhoven (NL)
(72) Inventor: POIESZ, Thomas, 5500AH Veldhoven (NL); VAN EDEN, Gustaaf, Galein, 5500AH Veldhoven (NL); AUSSEMS, Damien, Uriël, Boaz, 5500AH Veldhoven (NL); ENGELEN, Johannes, Bernardus, Charles, 5500AH Veldhoven (NL)
(74) Representative: ASML Netherlands B.V.

(57) **Abstract**

The present disclosure relates to an electrostatic clamp for a lithographic apparatus comprising a clamp body; a generally planar electrode arrangement comprising: a plurality of electrodes, arranged in a plurality of segments; and one or more connecting layers, configured to allow individual address of the plurality of electrodes; a plurality of burls projecting from the clamp body; and one or more demultiplexers in electrical communication with the one or more connecting layers, wherein the one or more demultiplexers are configured to sequentially address selections of the plurality of electrodes with a voltage source, thereby providing voltages to the selected electrodes.

## Description

### FIELD

The present invention relates to an electrostatic clamp. The electrostatic clamp may be suitable for use in lithographic apparatus. The present invention further relates to a method of using such an electrostatic clamp, and to a lithographic apparatus comprising such an electrostatic clamp.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Lithographic apparatus may suffer from one or more optical aberrations (e.g. coma or astigmatism). In addition, provided substrates may not be perfectly flat. Both optical aberrations and non-flat substrates may result in reduced pattern projection quality by placing projection surfaces of the substrate out of the focal surface.

It may be desirable to provide an apparatus that obviates or mitigates one or more problems associated with the prior art.

### SUMMARY

According to a first aspect there is provided an electrostatic clamp for a lithographic apparatus, comprising: a clamp body; a plurality of burls projecting from the clamp body and defining, with respective top surfaces thereof, a supporting surface for supporting an object on the electrostatic clamp; a generally planar electrode arrangement comprising at least two independently-addressable electrodes provided between insulators and separated in a direction normal to the plane of the electrode arrangement by an insulating layer, wherein a first electrode of said at least two electrodes, which first electrode is closer to the supporting surface than a second electrode of said at least two electrodes, at most partially overlaps the second electrode when viewed in a direction normal to the plane of the electrode arrangement; wherein the at least two independently-addressable electrodes are configured for generating an attractive electrostatic field for securing an object onto the plurality of burls when voltages are applied to the at least two independently-addressable electrodes during use. Advantageously, the provision of electrodes separated in a direction normal to the plane of the electrode arrangement allows the provision of multiple independently addressable electrodes adjacent to each other.

The object may be a substrate or a patterning device.

In an embodiment, the electrostatic clamp may further comprise a voltage source, configured to apply the voltages to the at least two independently-addressable electrodes, for the purpose of generating an attractive electrostatic field for securing an object onto the plurality of burls. The voltage source may be configured to apply a voltage difference between any of the least two independently-addressable electrodes in a range of 100 - 4000V, preferably 500 - 1500V.

In an embodiment, the insulating layer is 2 - 30 µm, preferably 4 - 15 µm thick.

In an embodiment, the separation in in the direction normal to the plane of the electrode sheet between any of the least two independently-addressable electrodes is at least 2µm. In an embodiment, the separation in the direction normal to the plane of the electrode sheet between any of the least two independently-addressable electrodes may be up to 30µm.

In an embodiment, the at least two independently-addressable electrodes are structured as a periodic array of elongate electrode plates. The total number of independently addressable electrodes may be four, for example.

In an embodiment, the at least two independently-addressable electrodes are situated so as to leave no gaps between the at least two electrodes when viewed in a direction normal to the plane of the electrode arrangement; preferably wherein an overlap between adjacent edges of the at least two electrodes is between 0 and 200 µm when viewed in a direction normal to the plane of the electrode arrangement. Advantageously, the lack of gaps between the electrodes maximises electrode area and thus clamping force.

In an embodiment, the at least two independently-addressable electrodes are situated so as to leave no overlap when viewed in a direction normal to the plane of the electrode arrangement; preferably wherein a gap between adjacent edges of the at least two electrodes of between 0 and 100 µm is present when viewed in a direction normal to the plane of the electrode arrangement.

In an embodiment, the at least two independently-addressable electrodes are structured such that long dimensions of the elongate electrode plates are configured to align with a scanning direction of the lithographic apparatus.

In an embodiment, the at least two independently-addressable electrode plates are structured such that their pitch is in a range of 1 - 15 mm, preferably 2-10 mm. In an embodiment, the at least two independently-addressable electrode plates are structured such that their pitch generally corresponds to an integral divisor of a maximum field width of a lithographic apparatus.

In an embodiment, the generally planar electrode arrangement comprises a generally planar electrode sheet overlying the clamp body, preferably wherein the plurality of burls are projecting from the clamp body through the electrode sheet. In an alternative embodiment, the generally planar electrode arrangement may be situated within the clamp body, that means, embedded within the clamp body.

In an embodiment, the insulating layer is composed of benzo-cyclo-butane (BCB). The insulating layer may in an embodiment be composed of glass.

According to a second aspect there is provided a method of using an electrostatic clamp according to the first aspect in a lithographic apparatus, wherein the method comprises: mounting an object onto the electrostatic clamp; applying different voltages of the same polarity to the at least two electrodes. The different voltages induce deformations in the object.

In an embodiment where the object is a substrate, the deformations induced in the substrate are configured to align perpendicularly to a scanning direction of the lithographic apparatus.

In an embodiment, a voltage difference between any of the least two independently-addressable electrodes is in a range of 100 - 4000V, preferably 500 - 1500V.

According to a third aspect there is provided a lithographic apparatus comprising: an illumination system configured to condition a radiation beam; a support structure constructed to support a patterning device, the patterning device being capable of imparting the radiation beam with a pattern in its cross-section to form a patterned radiation beam; a projection system configured to project the patterned radiation beam onto the substrate; and a substrate table constructed to hold a substrate comprising: an electrostatic clamp according to the first aspect; and a voltage source, configured to apply voltages to the at least two independently-addressable electrodes, for the purpose of generating an attractive electrostatic field for securing a substrate onto the plurality of burls.

Effects of the apparatus of the third aspect and of the method according to the second aspect are analogous to the effects of the electrostatic clamp of the first aspect. That means, various aspects and features of the invention set out above or below may be combined with various other aspects and features of the invention as will be readily apparent to the skilled person.

According to a fourth aspect there is provided an electrostatic clamp for a lithographic apparatus comprising: a clamp body; a generally planar electrode arrangement comprising a plurality of electrodes, arranged in a plurality of segments and one or more connecting layers, configured to allow individual address of the plurality of electrodes; a plurality of burls projecting from the clamp body; and one or more demultiplexers in electrical communication with the one or more connecting layers, wherein the one or more demultiplexers are configured to sequentially address selections of the plurality of electrodes with a voltage source, thereby providing voltages to the selected electrodes. The provision of a plurality of electrodes arranged in a plurality of segments allows a wide envelope of deformations to be applied to an object mounted on the clamp. In addition, the provision of a demultiplexer reduces the complexity of external connections. The plurality of burls define, with respective top surfaces thereof, a supporting surface for supporting an object on the electrostatic clamp. The object may be a substrate or a patterning device.

In an embodiment, the generally planar electrode arrangement comprises a generally planar electrode sheet overlying the clamp body, and wherein the plurality of burls are projecting from the clamp body through the electrode sheet. In an alternative embodiment, the generally planar electrode arrangement may be situated within the clamp body, that means, embedded within the clamp body.

In an embodiment, a length of the burls is in the range of 250 - 5000 µm.

In an embodiment, the one or more demultiplexers are configured to address electrodes for varying time periods, thereby varying the voltage of the electrodes.

In an embodiment, each demultiplexer is configured to electrically disconnect the electrode from the voltage source after the electrode has been addressed by the demultiplexer, and the electrode is configured to retain a voltage applied by the voltage source.

In an embodiment, the electrostatic clamp comprises a corresponding number of electrodes and burls.

In an embodiment, each electrode is disposed about a burl.

In an embodiment, multiple burls correspond to each of the plurality of electrodes. In an embodiment, an electrode may correspond to 1 to 10 burls. In an embodiment, the clamp may have between 10 and 50 segments. A segment may have tens or hundreds or thousands of electrodes.

In an embodiment, each segment of the electrostatic clamp is in electrical communication with a corresponding demultiplexer.

In an embodiment, electrodes of a segment are configured to be energized with the same polarity. A voltage difference between any of the least two electrodes within a segment may be between 100 and 4000V, for example up to 1000V.

In an embodiment, the electrodes are hexagonal.

In an embodiment, the electrostatic clamp comprises 100 to 50000 electrodes, for example 1000 to 10000 electrodes.

In an embodiment, the burls are substantially composed of porous chromium nitride.

In an embodiment, the electrodes are configured to provide between 10 and 20 nm of actuation normal to the electrode sheet.

In a fifth aspect, there is provided a method of using an electrostatic clamp according to the fourth aspect, wherein the method comprises: mounting an object onto the electrostatic clamp; using the one or more demultiplexers configured to sequentially address selections of the plurality of electrodes with a voltage source, thereby providing voltages to the selected electrodes. The voltages induce deformations in the object.

A voltage difference between any of the least two electrodes within a segment may be between 100 and 4000V, for example up to 1000V.

In a sixth aspect, there is provided a lithographic apparatus comprising: an illumination system configured to condition a radiation beam; a support structure constructed to support a patterning device, the patterning device being capable of imparting the radiation beam with a pattern in its cross-section to form a patterned radiation beam; a projection system configured to project the patterned radiation beam onto the substrate; and a substrate table constructed to hold a substrate comprising: an electrostatic clamp according to the fourth aspect.

In a seventh aspect, there is provided a lithographic apparatus comprising: an illumination system configured to condition a radiation beam; a support structure constructed to support a patterning device, the patterning device being capable of imparting the radiation beam with a pattern in its cross-section to form a patterned radiation beam; a projection system configured to project the patterned radiation beam onto the substrate; and a substrate table constructed to hold a substrate; the support structure for the patterning device comprising an electrostatic clamp according to the fourth aspect.

The generally planar electrode arrangement as referred to above may comprise a generally planar electrode sheet overlying the clamp body, and wherein the plurality of burls are projecting from the clamp body through the electrode sheet.

Effects of the apparatus of the sixth and seventh aspects and of the method according to the fifth aspect are analogous to the effects of the electrostatic clamp of the fourth aspect. That means, various aspects and features of the invention set out above or below may be combined with various other aspects and features of the invention as will be readily apparent to the skilled person.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 schematically illustrates a top view of a clamp according to an embodiment of the present disclosure;
- Figure 3 illustrates a selected cross section of the clamp according to the embodiment of Figure 2;
- Figure 4A schematically illustrates a top view of a truncated portion of an electrode sheet of the embodiment of Figures 2 and 3;
- Figure 4B illustrates a selected cross section of the truncated portion of the electrode sheet of Figure 4A;
- Figure 5 schematically represents a method of using the clamp according to the embodiment of Figures 2-4B.
- Figure 6 schematically illustrates a cross-section of the clamp according to the embodiment of Figures 2-5 in operation;
- Figure 7 schematically illustrates a top view of a clamp according to an alternative embodiment of the present disclosure;
- Figure 8A illustrates a top view of an electrode of the clamp according the embodiment of Figure 7;
- Figure 8B illustrates a selected cross section of the clamp according the embodiment of Figures 7 and 8A;
- Figure 9A illustrates a layer of a segment of an electrode sheet of the embodiment of Figures 7-8B;
- Figure 9B illustrates another layer of the segment of the electrode sheet shown in Figure 9A;
- Figure 9C illustrates another layer of the segment of the electrode sheet shown in Figures 9A and 9B; and
- Figure 10 schematically represents a method of using the clamp according to the embodiment of Figures 7-9C

### DETAILED DESCRIPTION

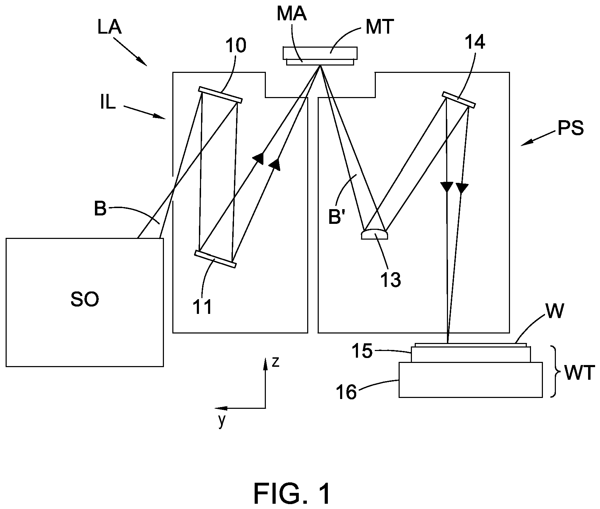

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table assembly WT configured to support a substrate W.

Substrate table assembly WT comprises a clamp 15 and a base 16. The clamp 15 secures the substrate W to the substrate table assembly WT. The base 16 couples the substrate table assembly WT to means for controlling the position and velocity of the substrate table assembly. The base 16 may also comprise metrology equipment such as interferometric mirrors.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The support structure MT and substrate table assembly WT may be movable in a scanning directions, labelled in Figure 1 as the y-direction. This allows exposure of a greater region of the patterning device MA in a single dynamic scanning exposure. The area exposed in a single dynamic scanning exposure may be referred to as an exposure area. Between scanning exposures, the substrate W (and substrate table assembly WT) may be moved in the x-direction so as to allow exposure of multiple exposure areas.

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

In the following description, where there are multiple instances of the same component, only selected instances have been labelled in the figures for clarity. In addition, like components will be referenced by like numerals. In addition, the embodiments of the present disclosure are described with reference to axes are provided with the figures, which are consistent throughout.

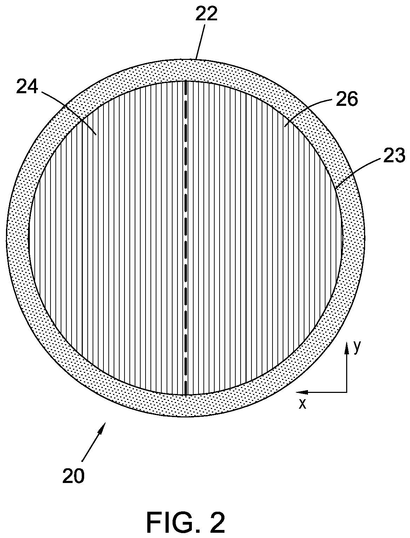

A description of an example type of electrostatic clamp (cf. clamp 15) is now provided with reference to Figures 2-6. Throughout this description, embodiments of the invention are detailed by means of description of an electrostatic clamp for holding an object being a substrate. Said description analogously applies to embodiments of the present invention relating to an electrostatic clamp for holding a patterning device.

Figure 2 schematically illustrates a top view of a clamp 20. The clamp 20 comprises a clamp body 22 and a generally planar electrode arrangement in the form of an electrode sheet 23 comprising a first half 24 and a second half 26. The first half 24 and the second half 26 of the electrode sheet 23 are configured to carry an electrical charge so as to generate an attractive electrostatic field for securing an object, such as a substrate (e.g. substrate W of Figure 1). The first half 24 and second half 26 are configured to be charged at opposite polarities.

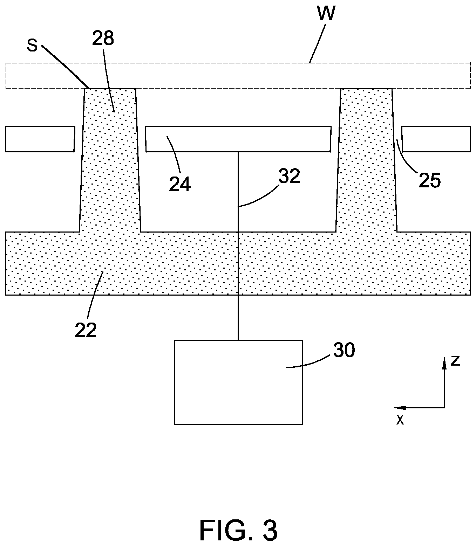

Although not shown in Figure 2 in the interests of clarity, the clamp 20 further comprises a plurality of burls 28 and, optionally, also a voltage source 30, best seen in Figure 3.

Figure 3 illustrates a selected cross section of the clamp 20 in the region of the first half 24. The plurality of burls 28 project from the clamp body 22. The plurality of burls 28 define, with respective top surfaces thereof, a supporting surface S for supporting a substrate on the electrostatic clamp. The burls 28 project through a corresponding plurality of holes 25 in the electrode sheet 23 so as to allow contact with the substrate. The first half 24 of the electrode sheet overlies the clamp body 22.

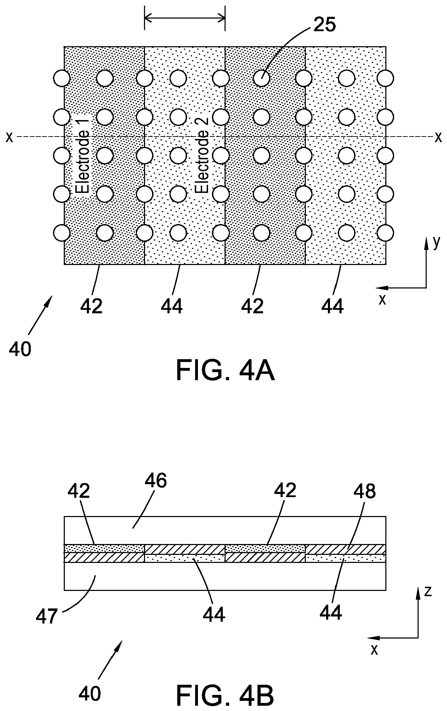

The first half 24 of the electrode sheet comprises at least two independently-addressable electrodes, which will be described in detail with reference to Figures 4A and Figure 4B. The two independently addressable electrodes are configured to carry charges on application of voltage. The voltage source 30 is in electrical communication with the first half 24 via a link 32. The voltage source 30 is configured to apply voltages to the two independently-addressable electrodes, for the purpose of generating an attractive electrostatic field for securing an object, such as a substrate, onto the plurality of burls.

Figure 4A schematically illustrates a truncated portion 40 of the first half 24 of the electrode sheet from a top view, showing the arrangement of the two independently-addressable electrodes. The first independently-addressable electrode is structured as a first periodic array of elongate first electrode plates 42. The second independently-addressable electrode is structured as a second periodic array of elongate second electrode plates 44. The first electrode plates and the second electrode plates 44 are mutually interposed in an alternating fashion.

Figure 4B illustrates a cross section X-X in the x-z plane of the truncated portion 40 of the first half 24 of Figure 4A. The first electrode plates 42 and the second electrode plates 44 are provided between an upper insulator 46 and a lower insulator 47. The first and second electrode plates 42, 44 are separated in a direction normal to the plane of the electrode sheet (i.e. the z-direction, normal to the x-y plane) by an insulating layer 48. The insulating layer acts to physically and electrically isolate the first and second electrode plates 42, 44 and by extension the first and second independently-addressable electrodes.

The first electrode, in the present example formed by the electrode plates 42, is closer to the supporting surface than the second electrode, in the present example formed by the electrode plates 44, and at most partially overlaps the second electrode when viewed in a direction normal to the plane of the electrode arrangement. At least in the example shown, the first and second electrode plates 42, 44 (and by extension, the two independently-addressable electrodes) are situated so as to leave no visible gaps or overlap between the electrodes when viewed in the direction normal to the plane of the electrode sheet. In some other embodiments there may be an overlap in the x-y plane between the first and second electrode plates 42, 44. Alternatively, the first and second electrode plates 42, 44 may be separated in a direction parallel to the plane of the electrode sheet (i.e. in the x-y plane) by up to 100µm. The first and second electrode plates 42, 44 may be separated in a direction parallel to the plane of the electrode sheet (i.e. in the x-y plane) by at least 10 or 30 or 50µm. A small separation in a direction parallel to the plane of the electrode sheet between the first and second electrode plates 42, 44 may provide further separation between the first and second electrode plates in addition to the separation in the z-axis, reducing the risk of electrical breakdown between the first and second electrode plates

The insulating layer 48 may be between 2µm and 30µm, preferably between 4 and 15 µm thick. The separation in the z-axis between the first and second electrode plates may be up to 30µm. The insulating layer 48 may be substantially composed of benzo-cyclo-butane (BCB) or of glass.

Although physically separated, the electrode plates of each independently-addressable electrode are in electrical communication with each other.

In use, the first and second independently-addressable electrodes are subjected to first and second voltages of the same polarity, respectively. The voltage difference between the two independently-addressable electrodes may, in an example, be between 100 and 5000V, or between 500 and 4000V.

Whilst the structure of the first half 24 of the electrode sheet has been described in detail with reference to Figures 4A and 4B, it will be appreciated that the structure of the second half 26 of the electrode sheet 23 may be substantially identical.

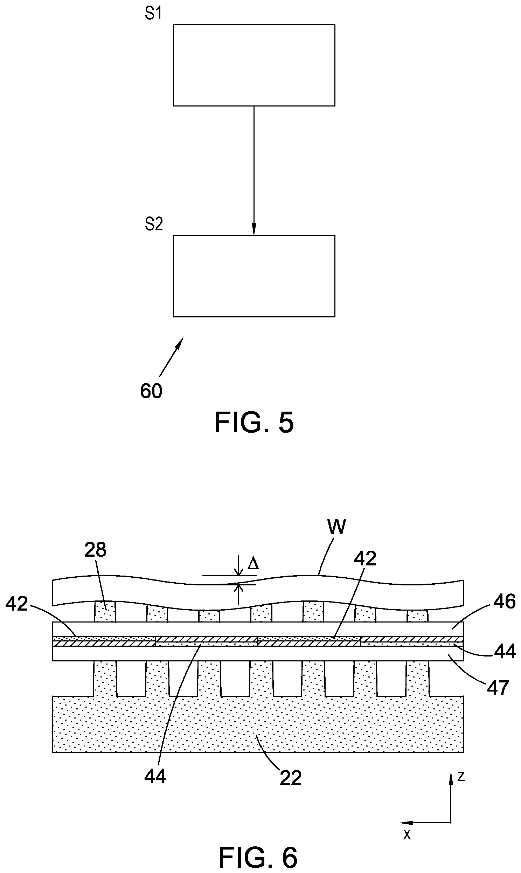

Figure 5 is schematic representation of a method 60 of using the electrostatic clamp 20.

At a step S1, a substrate W is mounted onto the electrostatic clamp 20.

At a step S2, different voltages of the same polarity are applied to the two independently - addressable electrodes of the first and second halves 24, 26 of the electrode arrangement, in the present example formed as an electrode sheet 23. The different voltages modulate the attractive forces experienced by portions of the substrate, inducing deformation described in further detail below.

Preferably, the electrostatic clamp is oriented such that the wave vectors(s) of the deformations align perpendicularly with to the scanning direction of the lithographic apparatus. Put alternatively, the electrostatic clamp is oriented such that induced variations in height are principally along a direction perpendicular to the scanning direction of the lithographic apparatus.

Figure 6 schematically illustrates the substrate W mounted on the clamp 20 (supported on burls 28) along cross section X-X. The first and second electrode plates 42, 44 are held at a first and second voltage, generating a field of periodically varying strength along the x-axis. Because of the elongate shape of the first and second electrode plates 42, 44 the field is substantially invariant along the y-axis. The attractive, or clamping force exerted on a portion of a substrate is related to the local field strength. The periodically varying local field strength along the x-axis induces a corresponding periodic deformation of the substrate W. In Figure 6, the peak-to-peak amplitude of deformation is indicated by Δ. The value of Δ is subject to a number of factors including the voltages, the stiffness of the substrate W and the burls 28. In some embodiments Δ may have a sensitivity of 1nm/100V.

In use, the scanning direction of the lithographic apparatus is parallel to the y-axis: actuation of the substrate W in the z-axis during a scanning exposure can mitigate flatness defects and/or aberration in the y-axis. The lithographic apparatus has less potential for actuation in the x-axis, perpendicular to the scan direction. Some lithographic apparatus cannot easily correct for higher order (e.g. order 3 or higher) optical aberrations or flatness defects perpendicular to the scanning direction (i.e. along the x-axis). Clamp 20 can mitigate these issues by inducing controlled corrective deformation of the substrate along the direction perpendicular to the scanning direction.

The width of the first and second electrode plates 42, 44 is correlated to an exposure area width or field width of the lithographic apparatus. The width of the electrode plates may be an integral divisor of the maximum field width, and sized to induce a corrective deformation. In some embodiments, the width of the first and second electrode plates may be an integral divisor or a standard field with. In some embodiments, the width of the first and second electrode plates 42, 44 may be between 1 and 15 mm, for example between 2 and 10 mm, such as about 3mm.

In a corrective deformation, the displacement of the substrate surface as shown in Figure 6 may act to bring the substrate surface into a focal plane of the projection system and may also contribute to overlay correction (in-plane correction), including with embodiments of the present invention where the object is a patterning device. Although the term "focal plane" may be used to describe the focus of the projection system, in practice the focus of the projection system may be non-planar due to aberrations of the projection system. Given this, the term "focal plane" may be interpreted as encompassing a distorted focus (i.e. non-planar). Embodiments of the invention may displace the substrate surface to provide the exposure area with a non-planar shape that corresponds with the focus of the projection system. In an alternative example, an exposure area of the substrate having e.g. a concave surface portion may be corrected by deforming the concave surface portion into a flat surface portion. In general, a displacement of the exposure area of the substrate may be applied which brings the substrate closer to a focus of the projection system.

In an alternative embodiment, the clamp 20 may also be oriented such that long axes of the first and second electrode plates are perpendicular to the scanning direction. This may allow for correction of projection system aberrations in the scanning direction. In general, projection system aberrations in the scanning direction may be correctable by raising and lowering the substrate table during a scanning exposure. However, in some lithographic apparatus some aberrations in the scanning direction are non-correctable via vertical movement of the substrate table. Embodiments of the invention may correct these aberrations.

The separation of the first and second independently-addressable electrodes in a direction normal to the plane of the electrode sheet may use voltage compensation. In an example, where a substantially uniform field may be desirable, the first electrode may be subjected to a lower voltage than the second electrode to compensate for the greater proximity of the first electrode plates 42 to the substrate relative to the second electrode plates 44.

Narrower electrode plates allow higher spatial frequencies of induced deformation. Higher spatial frequency deformations may be used to mitigate the effects of higher-order aberrations.

The electrostatic clamp 20 described with reference to Figures 2-6 has two electrodes per electrode sheet, arranged in an alternating array. In other embodiments there may three, four, five or more electrodes per electrode sheet. In other embodiments, one or more of the second, lower electrode plates 44 may extend partly underneath a first electrode plate 42 thereby creating an amount of overlap between two adjacent electrode plates, when viewed in a direction normal to the plane of the electrode arrangement. Said overlap may in an example be between 0 and 200 micrometers.

Whilst the first half 24 and second half 26 of the electrode sheet 23 overlie the clamp body 22 (best seen in Figure 3), other arrangements are possible. For example, the electrode arrangement of a clamp may be part of, or integrated within the clamp body.

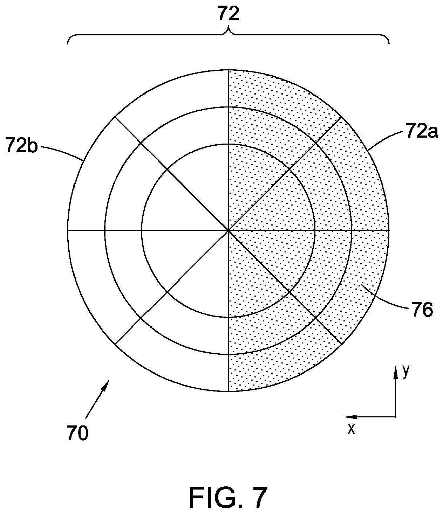

A description of an alternative type of electrostatic clamp for an object being a substrate or patterning device is now provided with reference to Figures 7-10.

Figure 7 schematically illustrates a top view of a clamp 70. Clamp 70 comprises a generally planar electrode arrangement, in the present example formed as a generally planar electrode sheet 72, comprising a plurality of electrodes, arranged in a plurality of segments 76. The electrode sheet 72 is separated into a first half 72a and a second half 72b.

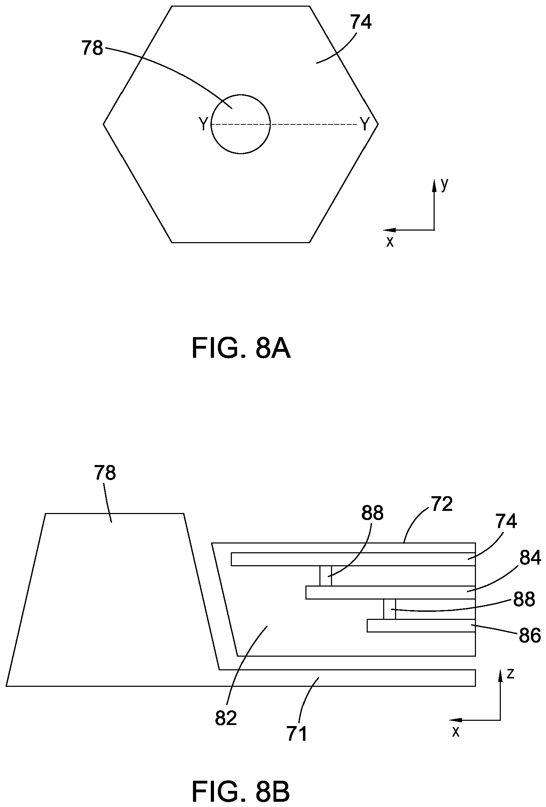

Figure 8A shows a single electrode 74 of clamp 70 and a corresponding burl 78. An electrode segment 76 comprises a plurality of electrodes 74. Figure 8B illustrates a cross section of the clamp 70 along cross-section Y-Y of Figure 8A, showing one of the electrodes 74 *in situ* in the electrode sheet 72. The electrode sheet 72 overlies the clamp body 71. In another example, the electrode arrangement may be part of, or integrated within the clamp body. The electrode sheet 72 comprises a dielectric body 82, which may itself comprise a plurality of insulating, dielectric layers. The electrode sheet 72 further comprises a plurality of electrodes 74, a first connecting layer 84 and a second connecting layer 86. The electrodes 74, the first connecting layer 84 and the second connecting layer 86 are separated from each other in a direction normal to the plane of the electrode sheet by the plurality of insulating/dielectric layers. The electrodes 74, the first connecting layer 84 and the second connecting layer 86 are contained within the dielectric body 82. The electrodes 74, the first connecting layer 84 and the second connecting layer 86 are in electrical communication via bridging connections 88.

Although not shown in Figure 8B, the electrode sheet 72 may further comprise one or more grounded shielding layers. In an example, a grounded shielding layer may be provided between the plurality of electrodes 74 and the first connecting layer 84.

The electrode sheet 72 may be separate from the camp body 71 or attached to it by an adhesion layer.

The planar electrodes 74, first and second connecting layers 84, 86 and the bridging connections 88 may be substantially fabricated from chromium using lithographic methods. The dielectric body 82 may be fabricated from fused silica, titania-silicate glass (e.g. ultra-low expansion glasses including Corning^{®} ULE^{®} ) or a borosilicate glass (e.g. Corning^{®} EAGLE XGO glass or Schott BOROFLOAT^{®}), for example.

In an example, the burls 78 may be fabricated from silicon carbide, or preferably chromium nitride, which may be porous.

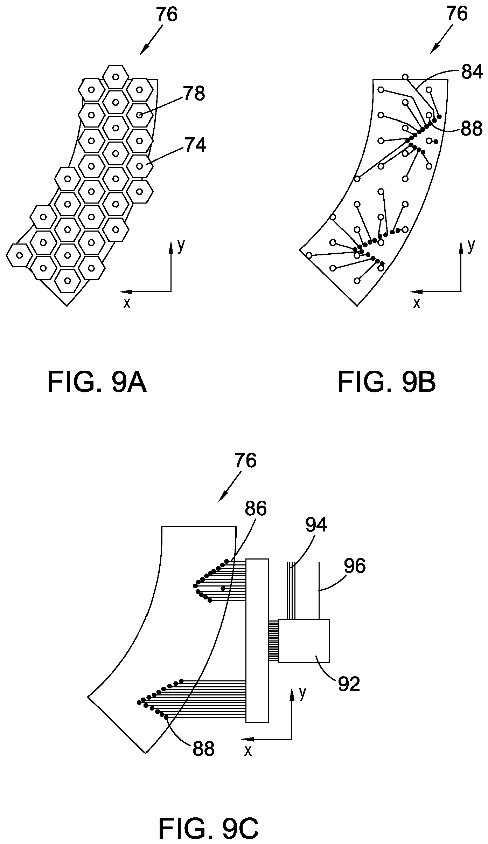

Figure 9A illustrates a segment 76 of the electrode sheet 72, viewed in a direction normal to the plane of the electrode sheet, exposing the electrodes 74. Each segment comprises a plurality of electrodes 74. The electrodes 74 are of a planar, hexagonal geometry. Each electrode 74 is disposed about a burl 78. The plurality of burls 78 project from the clamp body 71 through the electrode sheet 72. The plurality of burls 78 are arranged in a hexagonal lattice pattern. The hexagonal electrodes 74 are hexagonally-tiled. The electrodes 74 are physically and electrically isolated from each other by dielectric material. In some embodiments a gap (in the x-y plane) between each electrode 74 and its adjacent electrodes may be at least 10 or 30 or 50µm wide. In other embodiments the gap between each electrode 74 and its adjacent electrodes may be up to 100µm wide.

In some embodiments, each segment 76 may comprise around 1000 individual electrodes 74. The - smaller - amount of electrodes shown in the figures are merely shown to clearly explain the present invention. Alternatively, or additionally, some embodiments of clamp 70 may comprise at least 10000 individual electrodes 74 in total. Alternatively, or additionally, the electrodes 74 may have a width around 1.5mm.

Figure 9B illustrates the segment 76, viewed in a direction normal to the plane of the electrode sheet, exposing the first connecting layer 84 underlying the electrodes 74.

Figure 9C illustrates the segment 76, viewed in a direction normal to the plane of the electrode sheet, exposing the second connecting layer 86 underlying the first connecting layer 84. The second connecting layer 86 is in electrical communication with a demultiplexer 92.

The first and second connecting layers 84, 86 are configured to connect so as to provide an individual connection to each output channel of the demultiplexer 92, allowing individual address of the plurality of electrodes 74. In some embodiments, each segment 76 may be connected to a corresponding demultiplexer 92, in other embodiments multiple segments 76 may be connected to a single demultiplexer 92.

The demultiplexer 92 is configured to sequentially address selections of the plurality of electrodes 74 with a voltage source, thereby providing voltages to the selected electrodes. The voltage source is connected via high voltage connection 96 and the address of the electrodes 74 is controlled via low voltage connectors 94. To address all the electrodes 74, the selections of electrodes may be configured to span all the electrodes 74 of the corresponding segment(s) 76.

The operation and principles of demultiplexers are well known in the art. For example, the demultiplexer 92 may be configured to electrically disconnect an electrode 74 from the voltage source after the electrode 74 has been addressed by the demultiplexer 92, and the electrode may retain a voltage applied by the voltage source. After disconnection, the electrodes may be subject to a low leakage current and so discharge slowly, substantially retaining their voltage for an extended period. By periodically addressing each electrode 74 at an appropriate frequency, the voltage of each electrode can be substantially maintained. In some embodiments the RC time constant of the electrodes may be around 0.24s. The period between address of each electrode may be set to be around 1% of the RC time constant (e.g. up to 5% of the RC time constant). In this example, the electrodes 74 may be addressed at a frequency around 400Hz.

The demultiplexer 92 may be configured to address electrodes 74 for varying time periods, thereby varying the voltage of the electrodes 74.

The use of a demultiplexer allows a number of electrodes to be addressed by a lesser number of connectors, minimising the complexity of any external wiring harness.

In use the electrodes 74 can be addressed so as to induce a desired distribution of charge over the electrode sheet 72. The first half 72a and the second half 72b of the electrode sheet 72 are configured to be at opposite electrical polarities, so as to maintain overall neutrality.

A varying charge distribution across the plurality of electrodes 74 and the electrode sheet 72 generates a field of varying strength over the clamp 70. The attractive, or clamping force exerted on a portion of a substrate is related to the local field strength. The varying local field strength can induce deformation of any substrate (e.g. substrate W of Figure 1) mounted on clamp 70. The deformation of a substrate mounted to clamp 70 is facilitated by the compliance of the burls 78 which can compress to varying degrees depending on the load applied (this also applies for other embodiments).

Because of the hexagonal lattice arrangement of the electrodes 74 and the number of electrodes 74, the clamp 70 has a relatively isotropic and fine maximal spatial resolution and can effect a wide envelope of deformation patterns.

Thermally-induced stresses at the exposure area of a substrate mean that the clamping force at the exposure area of the substrate may be higher than at the rest of the substrate. As a result, at least some of the electrodes 74 underlying the exposure area may be addressed more frequently than the electrodes not underlying the exposure area. Electrodes 74 underlying areas of the substrate exposed to higher EUV fluence may addressed at a higher frequency. Electrodes 74 underlying an exposure area of the substrate may be addressed immediately before and/or during an exposure. During the exposure, the exposure area may be deformed in a selective and specific manner as described above.

Within a segment 76 of the electrode sheet 72, the difference between any of the least two electrodes within a segment may be up to 1000V, for example, so as to not exceed the breakdown field of the dielectric between electrodes 74. In general, the difference between any of the least two electrodes of each half of the electrode sheet 72a, 72b may also be up to 1000V, for example. In some embodiments, the electrodes 74 may be configured to provide between 10 and 20 nm of actuation normal to the electrode sheet 72.

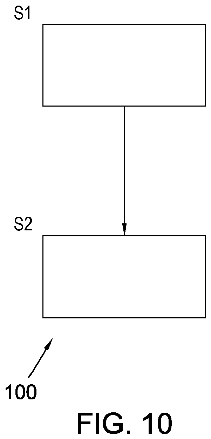

Figure 10 is a schematic representation of a method 100 of using the clamp 70.

At a step S1 the substrate is mounted onto the electrostatic clamp 70.

At a step S2 the demultiplexers 92 are used to sequentially address selections of the plurality of electrodes 74 with a voltage source, thereby providing voltages to the selected electrodes.

The pattern of voltages at the plurality of electrodes 74 induces a pattern of deformations in the substrate.

The deformation patterns may be selected so as to compensate for flatness defects of the substrate and a wide variety of higher-order aberrations.

In addition, it may be possible to operate at a lower average clamp voltage by only applying high voltages to areas of the clamp underlying the area currently under EUV exposure, where thermally-induced slip may be a significant issue. A lower average clamp voltage reduces electrostatic risks.

Although the clamp 70 described with reference to Figures 7-10 comprises a corresponding number of electrodes and burls in other embodiments the clamp may be structured such that multiple burls correspond to each of the plurality of electrodes.

In other embodiments, the electrodes could be of any number of shapes, not just hexagonal shapes. In particular, where the burls are not arranged in a hexagonal lattice (e.g. a square lattice), differently-shaped electrodes may be used (e.g. square electrodes).

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Aspects of the present disclosure are described in the following numbered clauses:
1. An electrostatic clamp for a lithographic apparatus comprising:
   a clamp body;
   a plurality of burls projecting from the clamp body and defining, with respective top surfaces thereof, a supporting surface for supporting an object on the electrostatic clamp;
      a generally planar electrode arrangement comprising at least two independently-addressable electrodes provided between insulators and separated in a direction normal to the plane of the electrode arrangement by an insulating layer, wherein a first electrode of said at least two electrodes, which first electrode is closer to the supporting surface than a second electrode of said at least two electrodes, at most partially overlaps the second electrode when viewed in a direction normal to the plane of the electrode arrangement;
      wherein the at least two independently-addressable electrodes are configured for generating an attractive electrostatic field for securing an object onto the plurality of burls when voltages are applied to the at least two independently-addressable electrodes during use.
2. The electrostatic clamp of the preceding clause, wherein the insulating layer is 10-30µm, preferably 4-15 µm thick.
3. The electrostatic clamp of any preceding clause, wherein the at least two independently-addressable electrodes are structured as a periodic array of elongate electrode plates.
4. The electrostatic clamp of any preceding clause, wherein the at least two independently-addressable electrodes are situated so as to leave no gaps between the at least two electrodes when viewed in a direction normal to the plane of the electrode arrangement; preferably wherein an overlap between adjacent edges of the at least two electrodes is between 0 and 200 µm when viewed in a direction normal to the plane of the electrode arrangement.
5. The electrostatic clamp of any preceding clause, wherein the at least two independently-addressable electrodes are situated so as to leave no overlap when viewed in a direction normal to the plane of the electrode arrangement; preferably wherein a gap between adjacent edges of the at least two electrodes of between 0 and 100 µm is present when viewed in a direction normal to the plane of the electrode arrangement.
6. The electrostatic clamp of clause 5, wherein the at least two independently-addressable electrodes are structured such that long dimensions of the elongate electrode plates are configured to align with a scanning direction of the lithographic apparatus.
7. The electrostatic clamp of clause 5 or 6, wherein the at least two independently-addressable electrode plates are structured such that their pitch is in a range of 1 - 15 mm, preferably 2 - 10 mm.
8. The electrostatic clamp of any preceding clause, further comprising a voltage source, configured to apply the voltages to the at least two independently-addressable electrodes, for the purpose of generating an attractive electrostatic field for securing an object onto the plurality of burls, wherein the voltage source is configured to apply a voltage difference between any of the least two independently-addressable electrodes in a range of 100 - 4000V, preferably 500 - 1500V.
9. The electrostatic clamp of any preceding clause, wherein the generally planar electrode arrangement comprises a generally planar electrode sheet overlying the clamp body, and wherein the plurality of burls are projecting from the clamp body through the electrode sheet.
10. The electrostatic clamp of preceding clause, wherein the insulating layer is composed of benzo-cyclo-butane (BCB).
11. A method of using an electrostatic clamp according to any one of the preceding clauses in a lithographic apparatus,
   wherein the method comprises:
      mounting an object onto the electrostatic clamp;
   applying different voltages of the same polarity to the at least two electrodes;
   wherein the different voltages induce deformations in the object.
12. The method of clause 11 wherein the object is a substrate and wherein deformations induced in the substrate are configured to align perpendicularly to a scanning direction of the lithographic apparatus.
13. A lithographic apparatus comprising:
   an illumination system configured to condition a radiation beam;
   a support structure constructed to support a patterning device, the patterning device being capable of imparting the radiation beam with a pattern in its cross-section to form a patterned radiation beam;
   a projection system configured to project the patterned radiation beam onto the substrate; and
   a substrate table constructed to hold a substrate comprising:
      an electrostatic clamp according to any one of the preceding clauses 1-10.

## Claims

1. An electrostatic clamp for a lithographic apparatus comprising:
a clamp body;
a generally planar electrode arrangement comprising:
a plurality of electrodes, arranged in a plurality of segments; and
one or more connecting layers, configured to allow individual address of the plurality of electrodes;
a plurality of burls projecting from the clamp body; and
one or more demultiplexers in electrical communication with the one or more connecting layers, wherein the one or more demultiplexers are configured to sequentially address selections of the plurality of electrodes with a voltage source, thereby providing voltages to the selected electrodes.

2. The electrostatic clamp according to claim 1, wherein the generally planar electrode arrangement comprises a generally planer electrode sheet overlying the clamp body, and wherein the plurality of burls are projecting from the clamp body through the electrode sheet.

3. The electrostatic clamp of any of the preceding claims wherein the one or more demultiplexers are configured to address electrodes for varying time periods, thereby varying the voltage of the electrodes.

4. The electrostatic clamp of any of the preceding claims wherein each demultiplexer is configured to electrically disconnect the electrode from the voltage source after the electrode has been addressed by the demultiplexer, and the electrode is configured to retain a voltage applied by the voltage source.

5. The electrostatic clamp of any of the preceding claims wherein the electrostatic clamp comprises a corresponding number of electrodes and burls, or, wherein multiple burls correspond to each of the plurality of electrodes.

6. The electrostatic clamp of any of the preceding claims wherein each electrode is disposed about a burl.

7. The electrostatic clamp of any of the preceding claims wherein each segment of the electrostatic clamp is in electrical communication with a corresponding demultiplexer.

8. The electrostatic clamp of any of the preceding claims wherein electrodes of a segment are configured to be energized with the same polarity.

9. The electrostatic clamp of any of the preceding claims wherein the electrodes are hexagonal.

10. The electrostatic clamp of any of the preceding claims wherein the electrostatic clamp comprises 100 to 50000 electrodes, preferably 1000 to 10000 electrodes.

11. The electrostatic clamp of any of the preceding claims wherein the burls are substantially composed of porous chromium nitride.

12. The electrostatic clamp of any of the preceding claims wherein the electrodes are configured to provide between 10 and 20 nm of actuation normal to the electrode sheet.

13. A method of using an electrostatic clamp according to any one of the preceding claims, wherein the method comprises:
mounting an object onto the electrostatic clamp;
using the one or more demultiplexers configured to sequentially address selections of the plurality of electrodes with a voltage source, thereby providing voltages to the selected electrodes.

14. A lithographic apparatus comprising:
an illumination system configured to condition a radiation beam;
a support structure constructed to support a patterning device, the patterning device being capable of imparting the radiation beam with a pattern in its cross-section to form a patterned radiation beam;
a projection system configured to project the patterned radiation beam onto the substrate; and
a substrate table constructed to hold a substrate;
wherein the support structure and/or the substrate table comprise an electrostatic clamp according to any one of the preceding claims 1-12.

15. An electrostatic clamp for a lithographic apparatus comprising:
a clamp body;
a plurality of burls projecting from the clamp body and defining, with respective top surfaces thereof, a supporting surface for supporting an object on the electrostatic clamp;
a generally planar electrode arrangement comprising at least two independently-addressable electrodes provided between insulators and separated in a direction normal to the plane of the electrode arrangement by an insulating layer, wherein a first electrode of said at least two electrodes, which first electrode is closer to the supporting surface than a second electrode of said at least two electrodes, at most partially overlaps the second electrode when viewed in a direction normal to the plane of the electrode arrangement;
wherein the at least two independently-addressable electrodes are configured for generating an attractive electrostatic field for securing an object onto the plurality of burls when voltages are applied to the at least two independently-addressable electrodes during use.
